# EUROPEAN PATENT APPLICATION

(11) **EP 2 693 487 A2**
(43) Date of publication of application: **05.02.2014**
(21) Application number: 13176312.0
(22) Date of filing: 12.07.2013
(51) Int. Cl.: H01L 31/0216

(54) **Thin film solar cell module and method of manufacturing the same**

(30) Priority: 31.07.2012 US 201261677768 P
(71) Applicant: Samsung SDI Co., Ltd., Yongin-si, Gyeonggi-do (KR)
(72) Inventor: Yang, Jung-Yup, Gyeonggi-do (KR); Ahn, Young-Kyoung, Gyeonggi-do (KR); Park, Bong-Kyoung, Gyeonggi-do (KR); Lebedev, Yury, Gyeonggi-do (KR)
(74) Representative: Taor, Simon Edward William

(57) **Abstract**

Embodiments of the invention provide a thin film solar cell module comprising: a lower substrate (121, 221), a thin film solar cell (120, 220) comprising a rear electrode layer (122, 222), a light absorption layer (124, 224) arranged over the rear electrode layer, and a transparent electrode layer (128, 228) arranged over the light absorption layer. In such embodiments, a protective layer (140, 240) is formed on the thin film solar cell, and a cover substrate (160, 260) is disposed over the protective layer. In such embodiments, the protective layer is formed of a moisture absorbing material. In some embodiments, a refractive index of the protective layer is between a refractive index of the cover substrate and a refractive index of the transparent electrode layer.

## Description

The present invention relates to a thin film solar cell module and a method of manufacturing the same.

Currently, the depletion of existing energy resources such as oil or coal is expected to continue and thus interest in alternative sources of energy has increased. From among these alternative sources, solar cells for directly transforming solar energy into electric energy by using semiconductor elements are regarded as next-generation battery cells.

Solar cells use a p-n junction and utilize various devices such as monocrystalline solar cells, polycrystalline solar cells, amorphous silicon solar cells, compound-based solar cells, dye-sensitized solar cells, etc., according to their materials, to improve efficiency and characteristics. Among these solar cells, widely utilized crystalline silicon solar cells have high cost materials and involve complicated processing procedures, compared to power generation efficiency. Thus, to solve problems of crystalline silicon solar cells, interest in thin film solar cells having low cost of production has increased.

Thin film solar cell modules include thin film solar cells, and edge sealing is additionally performed between a lower substrate and a cover substrate so as to protect the thin film solar cells from external moisture, etc.

The present invention provides a thin film solar cell module capable of preventing moisture penetration and improving a photoelectric conversion efficiency even when edge sealing is omitted and a method of manufacturing the same.

According to an aspect of the invention, there is provided a thin film solar cell module comprising: a lower substrate; a thin film solar cell comprising a rear electrode layer, a light absorption layer arranged over the rear electrode layer, and a transparent electrode layer arranged over the light absorption layer; a protective layer formed on the thin film solar cell; a cover substrate disposed over the protective layer; wherein the protective layer is formed of a moisture absorbing material.

In some embodiments, a refractive index of the protective layer is between a refractive index of the cover substrate and a refractive index of the transparent electrode layer. In some embodiments, the protective layer is arranged to cover a top surface of the transparent electrode layer and side surfaces of the transparent electrode layer and the light absorption layer.

In some embodiments, the protective layer is further arranged to cover a portion of a surface of rear electrode layer facing the cover substrate.

In some embodiments, a refractive index of the protective layer is between 1.5 and 2.0.

In some embodiments, a thin film solar cell module further comprises an encapsulation layer arranged between the protective layer and the cover substrate.

In some embodiments, a refractive index of the encapsulation layer is substantially equal to a refractive index of the cover substrate.

In some embodiments, the protective layer has a thickness of from about 50 nm to about 1000 nm.

In some embodiments, the thin film solar cell module further comprises a pair of ribbons in electrical contact with the rear electrode layer, wherein one of the pair of the ribbons is adjacent one end of the thin film solar cell and the other of the pair of the ribbons is adjacent an opposite end of the thin film solar cell.

In some embodiments, the protective layer is arranged to cover the pair of ribbons.

In some embodiments, the thin film solar cell further comprises a buffer layer arranged between the light absorption layer and the transparent electrode layer, optionally wherein the protective layer is arranged to cover side surfaces of the buffer layer.

In some embodiments, the thin film solar cell module comprises a plurality of thin film solar cells, wherein the protective layer of each thin film solar cell extends to join the protective layer of an adjacent thin film solar cell, optionally wherein the thin film solar cell module comprises a common protective layer for all the thin film solar cells. According to an embodiment of the present invention, even when edge sealing is omitted, moisture is prevented from penetrating into a thin film solar cell module, and a photoelectric conversion efficiency of a thin film solar cell module is improved.
FIG. 1 is a schematic cross-sectional view of a thin film solar cell module according to an embodiment of the present invention;
FIG. 2 is a graph illustrating light reflectivity of the thin film solar cell module of FIG. 1;
FIGS. 3 through 9 are cross-sectional views for explaining a method of manufacturing the thin film solar cell module of FIG. 1;
FIG. 10 illustrates a modified example of the thin film solar cell module of FIG. 1; and
FIGS. 11 through 13 are cross-sectional views illustrating a method of manufacturing the thin film solar cell module of FIG. 10.

Reference will now be made in detail to embodiments, examples of which are illustrated in the accompanying drawings, wherein like reference numerals refer to like elements throughout.

The elements are exaggerated, omitted or schematically illustrated for convenience and clarity of description, and sizes thereof do not fully reflect actual sizes. Also, in the description of the elements, in the case where an element is referred to as being "on" or "under" another element, the element may be "directly" or "indirectly" on or under the other element or intervening elements. The term "on" or "under" is described with respect to the drawings.

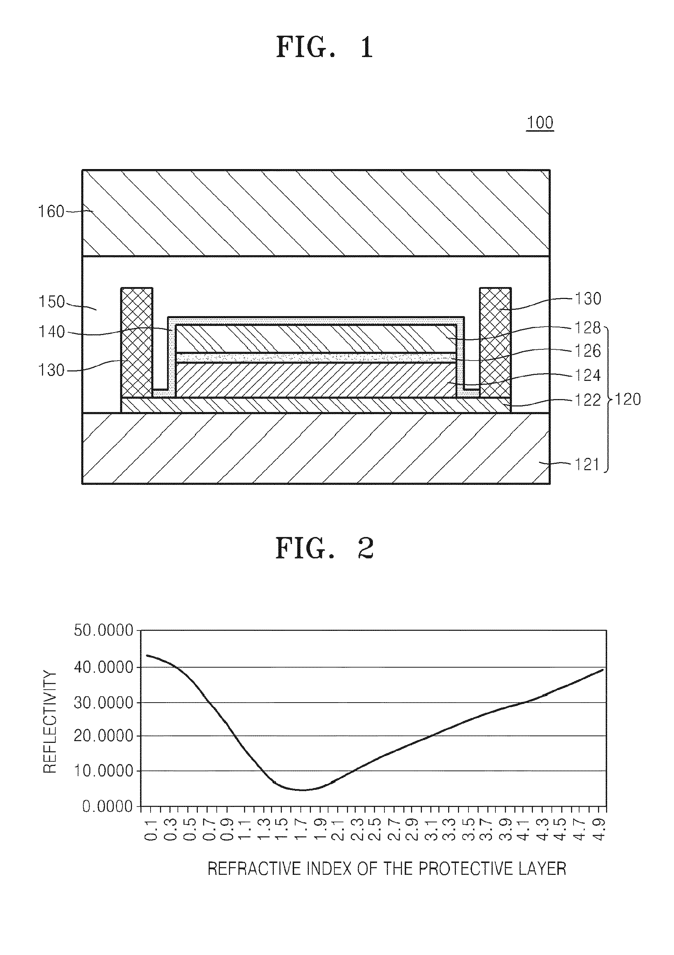

FIG. 1 is a schematic cross-sectional view of a thin film solar cell module 100 according to an embodiment of the present invention, and FIG. 2 is a graph illustrating light reflectivity of the thin film solar cell module of FIG. 1. Referring to FIG. 1, the thin film solar cell module 100 according to an embodiment of the present invention may include a thin film solar cell 120, a protective layer 140 formed on the thin film solar cell 120, a pair of ribbons 130 each attached to one of both ends of the thin film solar cell 120, an encapsulation layer 150 that seals the thin film solar cell 120 and the pair of ribbons 130, and a cover substrate 160 disposed on the encapsulation layer 150.

The thin film solar cell 120 is a device that directly transforms solar light energy into electric energy by using a photoelectric effect and may be a CIS-based thin film solar cell, an amorphous silicone thin film solar cell, a CdTd thin film solar cell, etc. Although the thin film solar cell 120 is hereinafter referred to as the CIGS thin film solar cell, the present invention is not limited thereto. The thin film solar cell 120 may be an amorphous silicone thin film solar cell or the CdTd thin film solar cell.

In this embodiment, the thin film solar cell 120 includes a lower substrate 121, and a rear electrode layer 122, a light absorption layer 124, a buffer layer 126, and a transparent electrode layer 128 that are sequentially stacked on the lower substrate 121.

The lower substrate 121 may be a glass substrate, a stainless steel substrate, or a polymer substrate. For example, the glass substrate may use soda lime glass, and the polymer substrate may use polyimide. However, the present invention is not limited thereto.

The rear electrode layer 122 may be formed of a metallic material having excellent conductivity and light reflectivity such as molybdenum (Mo), aluminum (Al) or copper (Cu) in order to collect charges formed by the photoelectric effect and reflect light that transmits the light absorption layer 124 to allow the light absorption layer 124 to reabsorb the light. In particular, the rear electrode layer 122 may be formed of molybdenum (Mo) in consideration of high conductivity, an ohmic contact with the light absorption layer 124, a high temperature stability in an atmosphere of selenium (Se), etc. Also, the rear electrode layer 122 may be formed as a multilayer so as to secure a junction with the lower substrate 121 and a resistance characteristic of the rear electrode layer 122.

The lithe absorption layer 124 may be formed of a copper-indium-selenide (CIS)-based compound including copper (Cu), indium (In), and selenide (Se) to form a p-type semiconductor layer, and absorbs incident solar light. Also, the light absorption layer 124 may be formed of a copper-indium-gallium-selenide (Cu(In,Ga)Se₂,CIGS)-based compound including copper (Cu), indium (In), gallium (Ga), and selenide (Se). The light absorption layer 124 may be formed in various ways to have a thickness in a range from about 0.7 µm to about 2 µm.

The buffer layer 126 reduces a band gap difference between the light absorption layer 124 and the transparent electrode layer 128, which will be described later, and reduces recombination of electrons and holes that may occur on an interface between the light absorption layer 124 and the transparent electrode layer 128. The buffer layer 126 may be formed of CdS, ZnS, In₂S₃, ZnₓMg₍₁₋ₓ₎O, etc.

The transparent electrode layer 128 constitutes a P-N junction and is formed of a conductive material having a property capable of transmitting light such as ZnO:B, ZnO:Al, ZnO:Ga, indium tin oxide (ITO) or indium zinc oxide (IZO), etc. Thus, the transparent electrode layer 128 may transmit incident light and simultaneously collect charges formed by the photoelectric effect.

The protective layer 140 is formed on the thin film solar cell 120. In greater detail, the protective layer 140 is formed on a top surface of the transparent electrode layer 128 and is formed to cover a part of a top surface of the rear electrode layer 122 which is exposed during a process of attaching the pair of ribbons 130 and side surfaces of the light absorption layer 124, the buffer layer 126, and the transparent electrode layer 128.

The protective layer 140 is formed of a moisture absorbing material. For example, the protective layer 140 may be formed of Al₂O₃ or MgO but is not limited thereto, and may further include at least one from aluminum (Al), magnesium (Mg), manganese (Mn), iron (Fe), calcium (Ca), barium (Ba), strontium (Sr) and oxides thereof. Thus, the protective layer 140 absorbs moisture penetrated into the thin film solar cell module 100, and thus the thin film solar cell 120 may be protected from the moisture penetrated into the thin film solar cell module 100.

Also, in order to minimize reflection of solar light, which is incident to a front surface of the cover substrate 160, by the protective layer 140, a refractive index of the protective layer 140 may be a value between a refractive index of the cover substrate 160 and a refractive index of the transparent electrode layer 128.

For example, as a refractive index of the cover substrate 160 formed of a glass material is about 1.5 and a refractive index of the transparent electrode layer 128 formed of ITO is about 2, and thus a refractive index of the protective layer 140 may have a value in a range of about 1.5 to about 2. Also, a refractive index of the encapsulation layer 150, which may be formed of ethylene-vinyl acetate copolymer resin, is set to be same as a refractive index of the cover substrate 160, and thus when setting a refractive index of the protective layer 140, the refractive index of the encapsulation layer 150 will not be particularly considered.

FIG. 2 shows a reflectivity of the thin film solar cell module 100 according to a refractive index of the protective layer 140 obtained from a light reflectivity equation of a multi-layer structure is when refractive indices of the cover substrate 160 and the encapsulation layer 150 are about 1.5 and a refractive index of the transparent electrode layer 128 is about 2. As shown in FIG. 2, when a refractive index of the protective layer 140 has a value between a refractive index of the cover substrate 160 and a refractive index of the transparent electrode layer 128, the reflectivity of solar light incident to a top surface of the cover substrate 160 may be minimized, and thus reduction in an amount of light arriving to the light absorption layer 124 may be prevented.

A thickness of the protective layer 140 may be in a range of about 50 nm to about 1000 nm. When a thickness of the protective layer 140 is less than 50 nm, an effect of absorbing the moisture penetrated into the thin film solar cell module 100 is not sufficient. On the other hand, when a thickness of the protective layer is greater than 1000 nm, an amount of light penetrated may be reduced as a light absorptivity of the moisture absorbing material is increased. Thus, a thickness of the protective layer 140 may be in a range of about 50 nm to about 1000 nm.

The protective layer 140 formed in such a manner absorbs the moisture penetrated into the thin film solar cell module 100, and thus moisture penetrating into the thin film solar cell 120 may be prevented, and at the same time, a photoelectric conversion efficiency of the thin film solar cell 120 may be improved as the protective layer 140 serves as a antireflection film.

The pair of ribbons 130 are attached onto the rear electrode layer 122 exposed at both sides of the thin film solar cell 120. The pair of ribbons 130 collect electrons and holes that occur in the thin film solar cell 120, and are connected to a lead line of a junction box (not shown) that prevents a counter flow of current.

The encapsulation layer 150 may be disposed between the pair of ribbons 130 and seal the thin film solar cell 120, together with the pair of ribbons 130, thereby blocking moisture or oxygen that may adversely affect the thin film solar cell 120.

The encapsulation layer 150 may be formed of ethylene vinyl acetate (EVA) copolymer resin, polyvinyl butyral (PVB), EVA partial oxide, silicon resin, ester-based resin, olefin-based resin, etc. The encapsulation layer 150 seals the thin film solar cell 120 and the pair of ribbons 130, and primarily blocks moisture and oxygen that may damage the thin film solar cell 120.

The cover substrate 160 may be formed of glass in such a way that sun light may be transmitted through the cover substrate 160, and may be further formed of tempered glass so as to protect the thin film solar cell 120 from an external shock, etc. Also, the cover substrate 160 may be further formed of low iron tempered glass so as to prevent solar light from being reflected and increase transmittance of solar light.

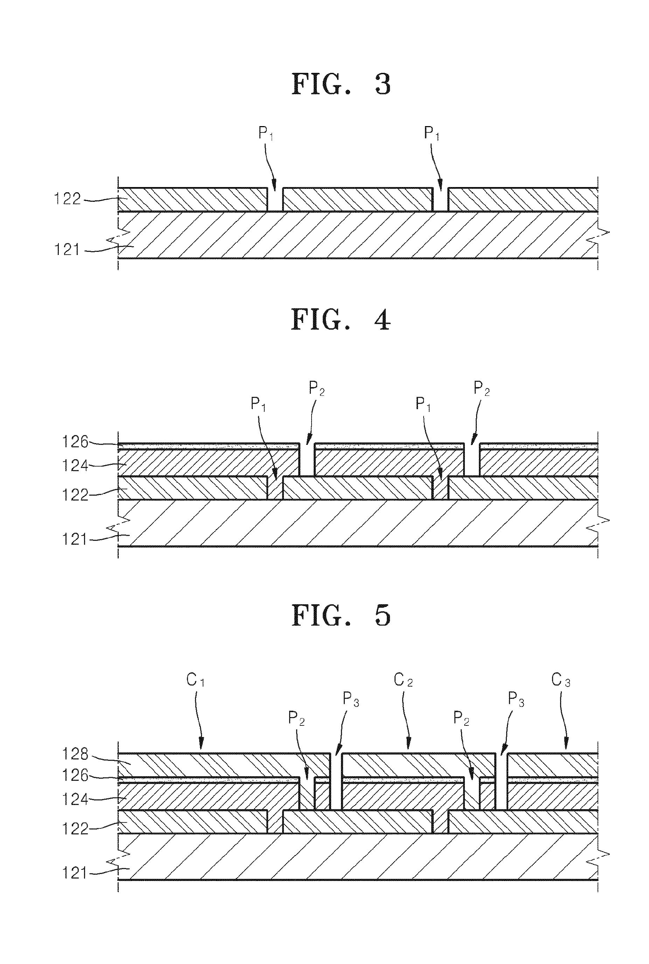

FIGS. 3 through 9 are cross-sectional views for explaining a method of manufacturing the thin film solar cell module 100 of FIG. 1.

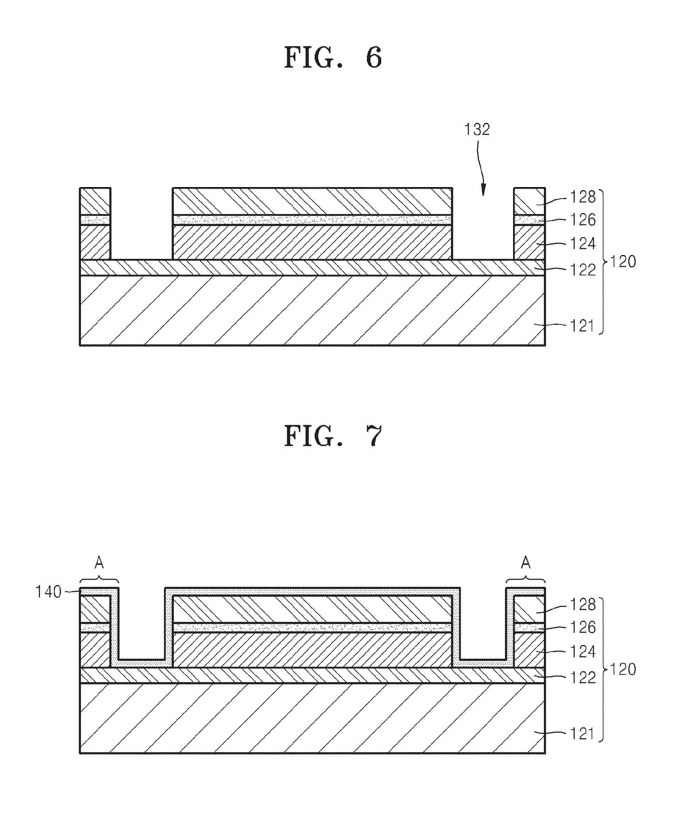

FIGS. 3 through 9 are detailed views of a structure of the thin film solar cell 120 and the method of manufacturing the thin film solar cell module 100 of FIG. 1 as well. FIGS. 6 through 9 are views for explaining the method of manufacturing the thin film solar cell module 100 by using the thin film solar cell 120 manufactured in FIGS. 3 through 5.

A method of manufacturing the thin film solar cell 120 will now be described with reference to FIGS. 3 through 5.

Referring to FIG. 3, the rear electrode layer 122 is formed on the lower substrate 121, first patterning is performed thereon, and the rear electrode layer 122 is split into a plurality of layers.

The rear electrode layer 122 may be formed by applying a conductive paste on the lower substrate 121 and thermally processing the conductive paste or through processing such as plating. Also, the rear electrode layer 122 may be formed through sputtering using a molybdenum (Mo) target.

The first patterning may use, for example, laser scribing. The laser scribing may be performed by irradiating a laser from a bottom surface of the lower substrate 121 to the lower substrate 121 and evaporating a part of the rear electrode layer 122 or by irradiating a laser from a top surface of the rear electrode layer 122 and evaporating a part of the rear electrode layer 122, and thus a first pattern portion P1 that splits the rear electrode layer 122 into the plurality of layers with uniform gaps therebetween may be formed.

Thereafter, referring to FIG. 4, the light absorption layer 124 and the buffer layer 126 are formed and then second patterning is performed thereon.

The light absorption layer 124 may be formed using i) a co-evaporation method of heating copper (Cu), indium (In), gallium (Ga), and selenium (Se) contained in a small electric furnace installed in a vacuum chamber and performing a vacuum and evaporation process thereon, and ii) a sputtering/selenization method of forming a CIG-based metal precursor layer on the rear electrode layer 122 by using a copper (Cu) target, an indium (In) target, and a gallium (Ga) target, thermally processing the CIG-based metal precursor layer in an atmosphere of hydrogen selenide (H2Se), and reacting the CIG-based metal precursor layer with selenium (Se). Also, the light absorption layer 124 may be formed using an electro-deposition method, a molecular organic chemical vapor deposition (MOCVD) method, etc.

The buffer layer 126 may be formed using a chemical bath deposition (CBD) method, an atomic layer deposition (ALD) method, an ion layer gas reaction (ILGAR) method, etc.

In this regard, the second patterning may use, for example, mechanical scribing that is performed to form a second pattern portion P2 by moving a sharp tool such as a needle in a direction parallel to the first pattern portion P1 at a point spaced apart from the first pattern portion P1. However, the present invention is not limited thereto. For example, the second patterning may use laser scribing.

The second pattern portion P2 splits the light absorption layer 124 into a plurality of layers and extends to a top surface of the rear electrode layer 122 to allow the rear electrode layer 122 to be exposed.

Referring to FIG. 5, after the transparent electrode layer 128 is formed, third patterning is performed.

The transparent electrode layer 128 may be formed of a transparent and conductive material such as ZnO:B, ZnO:Al, ZnO:Ga, indium tin oxide (ITO) or indium zinc oxide (IZO), etc., and may be formed using a metalorganic chemical vapor deposition (MOCVD), a low pressure chemical vapor deposition (LPCVD), or a sputtering method, etc.

The transparent electrode layer 128 is formed in the second pattern portion P2 to contact the rear electrode layer 122 exposed by the second pattern portion P2 and electrically connect the light absorption layer 124 that are split into the plurality of layers by the second pattern portion P2.

The transparent electrode layer 128 may be split into a plurality of layers by a third pattern portion P3 formed at a location different from the first pattern portion P1 and the second pattern portion P2.

The third patterning may use laser scribing or mechanical scribing. The third pattern portion P3 formed by performing the third patterning may be a groove formed in parallel with the first pattern portion P1 and the second pattern portion P2, extend to the top surface of the rear electrode layer 121, and thus a plurality of photoelectric conversion units C1∼C3 may be formed. Also, the third pattern portion P3 may act as an insulation layer between the photoelectric conversion units C1∼C3 to connect the photoelectric conversion units C1∼C3 in series with each other.

The method of manufacturing the thin film solar cell module 100 of FIG. 1 will now be described with reference to FIGS. 6 through 9.

Referring to FIG. 6, edge deletion is performed on the thin film solar cell 120, and then the top surface of the rear electrode layer 122 is exposed to attach the pair of ribbons 130 thereto.

After the edge deletion is performed, openings 132 exposing the rear electrode layer 122 are formed at both ends of the rear electrode layer 122. The openings 132 may be grooves that are formed in parallel with the first through third pattern portions P1 through P3. Also, the ribbons 130 are to be disposed in the openings 132, and thus a width of the openings 132 may be at least greater than a width of the ribbons 130. The openings 132 may be formed using mechanical scribing, laser scribing, or a selective etching process.

Subsequently, as shown in FIG. 7, the protective layer 140 is formed over the entire construction shown in FIG. 6.

The protective layer 140 may be formed of Al₂O₃ or MgO to absorb the moisture penetrated into the thin film solar cell module 100. Here, a refractive index of the protective layer 140 may be controlled by controlling oxygen partial pressure when depositing Al₂O₃ or MgO.

For example, when the protective layer 140 is formed of Al₂O₃, a refractive index of the protective layer 140 is lowered as the oxygen partial pressure is higher when depositing a Al₂O₃ thin film. That is, as a refractive index of the protective layer 140 may be changed, the protective layer 140 may have a refractive index value between refractive indices of the cover substrate 160 and the transparent electrode layer 128 in consideration of values of the refractive indices of the cover substrate 160 and the transparent electrode layer 128.

The protective layer 140 may be formed by using a sputtering method, a low pressure chemical vapor deposition (LPCVD) method, a metalorganic chemical vapor deposition (MOCVD) method, a plasma enhanced chemical vapor deposition (PECVD) method, an atomic layer deposition (ALD) method, a spin coating method, a printing method, etc. Also, the protective layer 140 may be formed at a temperature of 200°C or less in order to prevent thermal damage on the buffer layer 126 and the transparent electrode layer 128.

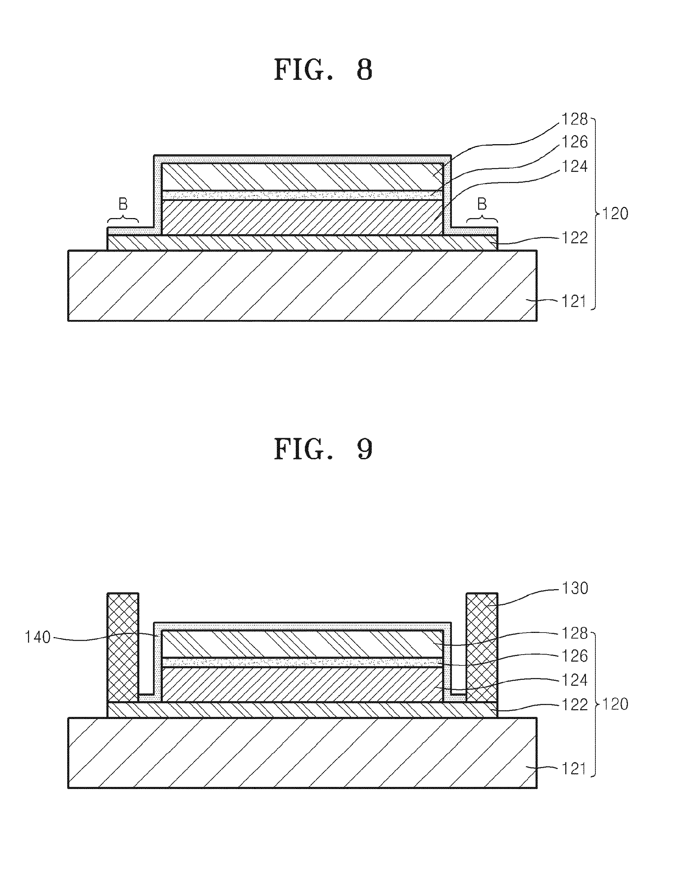

After forming the protective layer 140, an edge deletion process is performed as shown in FIG. 8. The edge deletion process is performed on all the edges of the thin film solar cell module 120 and removes A portions of FIG. 7. In this regard, the thin film solar cell 120 formed on the edges of the lower substrate 121 is removed, and thus a bonding force between the encapsulation layer 150 and the lower substrate 121 is increased, and the thin film solar cell 120 may be prevented from being exposed to an external environment.

Next, as shown in FIG. 9, an electrode exposure process for removing B portions of FIG. 8 may be performed to expose both ends of the rear electrode layer 122. Meanwhile, an order of the electrode exposure process and the edge deletion process may be switched.

After the electrode exposure process, the pair of ribbons 130 are attached on the exposed rear electrode layer 122.

The pair of ribbons 130 may be attached on the exposed rear electrode layer 122 by coating a flux on the exposed rear electrode layer 122, disposing the pair of ribbons 130 on the flux, and performing a tabbing process through heat treatment. Alternatively, the pair of ribbons 130 may be attached on the rear electrode layer 122 by using a conductive tape, an ultrasonic welding process, an ultrasonic soldering process, etc.

The pair of ribbons 130 are disposed in the openings 132 of FIG. 6 as shown and described in relation to FIG. 6, and thus the pair of ribbons 130 are formed along a direction of the openings 132 of FIG. 6.

After attaching the pair of ribbons 130, the encapsulation layer 150 and the cover substrate 160 of FIG. 1 may be disposed to form the thin film solar cell module 100 as shown in FIG. 1 through laminating.

The thin film solar cell module 100 formed in such a manner is laminated.

The encapsulation layer 150 primarily prevents external moisture penetration, and the protective layer 140 secondarily absorbs moisture penetrated into the thin film solar cell module 100, and thus moisture may not be penetrated into the thin film solar cell 120. Therefore, a conventional edge sealing unit may be omitted. Also, the protective layer 140 also serves as an antireflection film, and a photoelectric conversion efficiency may be improved.

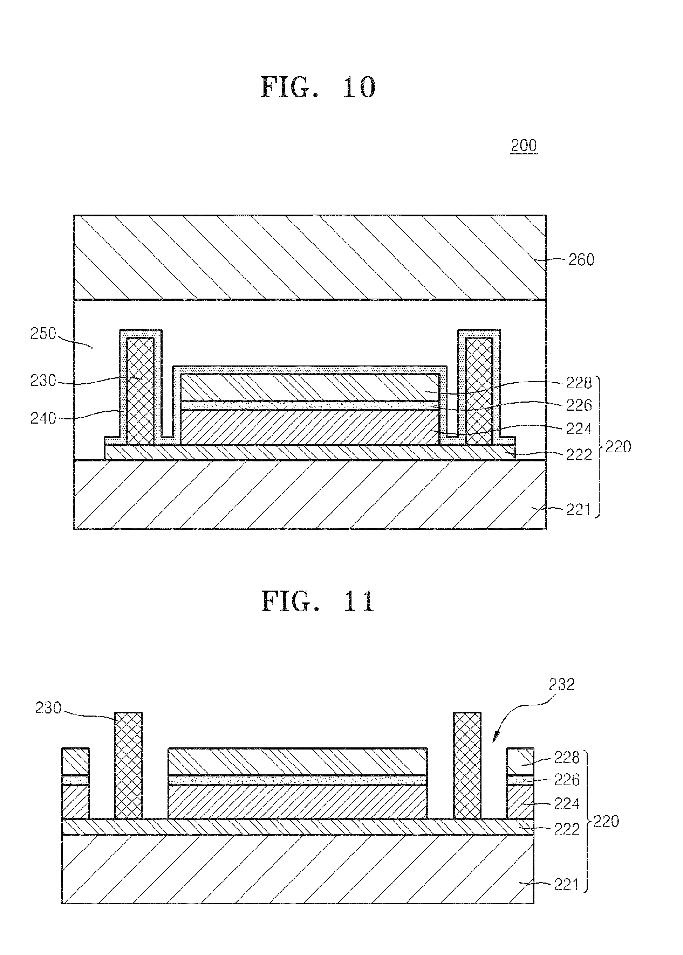

FIG. 10 illustrates a modified example of the thin film solar cell module of FIG. 1.

The thin film solar cell module 200 of the embodiment of FIG. 10 includes a thin film solar cell 220, a pair of ribbons 230 each attached to one of both ends of the thin film solar cell 220, a protective layer 240 formed on the thin film solar cell 220 and the pair of ribbons 230, an encapsulation layer 250 formed on the protective layer 240, and a cover substrate 260 on the encapsulation layer 250.

The thin film solar cell 220 may be, for example, a CIGS thin film solar cell, and the thin film solar cell 220 may include a lower substrate 221, and a rear electrode layer 222, a light absorption layer 224, a buffer layer 226, and a transparent electrode layer 228 that are sequentially stacked on the lower substrate 221.

The thin film solar cell 220, the encapsulation layer 250, and the cover substrate 260 are the same as the thin film solar cell 120, the encapsulation layer 150, and the cover substrate 160 that are shown and described in FIG. 1, and thus a detailed description will be omitted here, and only differences therebetween will be described hereinafter.

Referring to FIG. 10, the cover layer 240 is formed to cover the pair of ribbons 230. In greater detail, the protective layer 240 is formed to cover a top surface of the transparent electrode layer 228, side surfaces of the light absorption layer 224, the buffer layer 226, and the transparent electrode layer 228, a part of a top surface of the rear electrode layer 222, and a top surface and both side surfaces of each of the pair of ribbons 230.

In this regard, corrosion of the pair of ribbons 230 may be effectively prevented by sealing surfaces of the pair of ribbons 230 with the protective layer 240 having a moisture absorbing effect.

Meanwhile, the protective layer 240 has a refractive index value between refractive indices of the transparent electrode layer 228 and a cover substrate (not shown), and thus the protective layer 240 may serve as an antireflection film at the same time and may improve a photoelectric conversion efficiency of the thin film solar cell 220.

FIGS. 11 through 13 are cross-sectional views illustrating a method of manufacturing the thin film solar cell module of FIG. 10.

Meanwhile, the thin film solar cell 220 of the thin film solar cell module 200 is the same as the thin film solar cell 120 shown and described in FIG. 1. Accordingly, the method of manufacturing the thin film solar cell 220 is the same as the method of manufacturing the thin film solar cell 120 shown and described in FIGS. 3 through 6, and thus the same description is omitted here, and only differences therebetween will be described hereinafter.

Referring to FIGS. 11 through 13 to describe the method of manufacturing the thin film solar cell module 200 of FIG. 10, first, the rear electrode layer 222, the light absorption layer 224, the buffer layer 226, and the transparent electrode layer 228 are sequentially stacked on the lower substrate 221 as shown in FIG. 11 to form the thin film solar cell 220. Then, openings 232 exposing the rear electrode layer 222 may be formed in both sides of the thin film solar cell 220, and the pair of ribbons 230 are each attached to the top surface of the rear electrode layer 222 exposed by the openings 232.

The openings 232 may be formed using mechanical scribing, laser scribing, or a selective etching process, and since the ribbons 230 are to be disposed in the openings 232, a width of the openings 232 may be formed at least greater than a width of the ribbons 230.

The pair of ribbons 230 may be attached to the rear electrode layer 222 through a tabbing process. Alternatively, the pair of ribbons 230 may be attached on the rear electrode layer 122 by using a conductive tape, an ultrasonic welding process, an ultrasonic soldering process, etc.

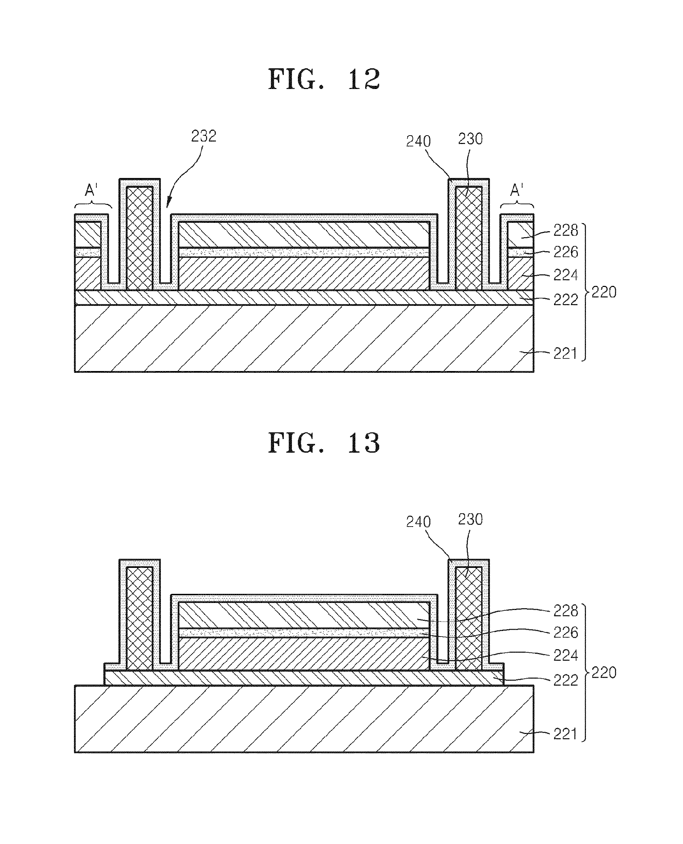

After forming the pair of ribbons 230 in such a manner, the protective layer 240 is formed in the same manner as in FIG. 12.

The protective layer 240 may be formed by using a sputtering method, a low pressure chemical vapor deposition (LPCVD) method, a metalorganic chemical vapor deposition (MOCVD) method, a plasma enhanced chemical vapor deposition (PECVD) method, an atomic layer deposition (ALD) method, a spin coating method, a printing method, etc. Also, the protective layer 240 may be formed at a temperature of 200°C or less in order to prevent thermal damage on the buffer layer 226 and the transparent electrode layer 228.

Next, an edge deletion process is performed as shown in FIG. 13.

The edge deletion process is performed on all the edges of the thin film solar cell module 220 and removes A' portions of FIG. 12. In this regard, the thin film solar cell 220 formed on the edges of the lower substrate 221 is removed, and thus a bonding force between the encapsulation layer 250 and the lower substrate 221 is increased, and the thin film solar cell 220 may be prevented from being exposed to an external environment.

Subsequently, after disposing the encapsulation layer 250 and the cover substrate 260, the thin film solar cell module 200 of FIG. 10 may be formed through a lamination process.

The encapsulation layer 250 primarily prevents external moisture penetration, and the protective layer 240 secondarily absorbs moisture penetrated into the thin film solar cell module 200, and thus moisture may not be penetrated into the thin film solar cell 220. Also, the encapsulation layer 250 is formed to cover the pair of ribbons 230, and thus corrosion of the pair of ribbons 230 may be effectively prevented. Moreover, the protective layer 240 serves as an antireflection film at the same time, and thus a photoelectric conversion efficiency of the thin film solar cell 220 may be improved.

A thin film solar cell module according to an embodiment of the present invention is not limited to the configuration and the method of the embodiments described above, and whole or parts of each of the embodiments may be selectively combined to make various modifications.

As discussed above, embodiments of the invention provide a thin film solar cell module comprising: a lower substrate, a thin film solar cell comprising a rear electrode layer, a light absorption layer arranged over the rear electrode layer, and a transparent electrode layer arranged over the light absorption layer. In such embodiments, a protective layer is formed on the thin film solar cell, and a cover substrate is disposed over the protective layer. In such embodiments, the protective layer is formed of a moisture absorbing material. In some embodiments, a refractive index of the protective layer is between a refractive index of the cover substrate and a refractive index of the transparent electrode layer.

Also, it should be understood that the exemplary embodiments described herein should be considered in a descriptive sense only and not for purposes of limitation. Descriptions of features or aspects within each embodiment should typically be considered as available for other similar features or aspects in other embodiments

## Claims

1. A thin film solar cell module comprising:
a lower substrate (121, 221);
a thin film solar cell (120, 220) comprising a rear electrode layer (122, 222), a light absorption layer (124, 224) arranged over the rear electrode layer (122, 222), and a transparent electrode layer (128, 228) arranged over the light absorption layer (124, 224) ;
a protective layer (140, 240) formed on the thin film solar cell (120, 220);
a cover substrate (160, 260) disposed over the protective layer (140, 240);
wherein the protective layer (140, 240) is formed of a moisture absorbing material.

2. A thin film solar cell module according to claim 1, wherein a refractive index of the protective layer (140, 240) is between a refractive index of the cover substrate (160, 260) and a refractive index of the transparent electrode layer (128, 228).

3. A thin film solar cell module according to claim 1 or 2, wherein the protective layer (140, 240) is arranged to cover a top surface of the transparent electrode layer (128, 228) and side surfaces of the transparent electrode layer (128, 228) and the light absorption layer (124, 224).

4. A thin film solar cell module according to claim 3, wherein the protective layer (140, 240) is further arranged to cover a portion of a surface of rear electrode layer (122, 222) facing the cover substrate (160, 260).

5. A thin film solar cell module according to any one of claims 1 to 4, wherein a refractive index of the protective layer (140, 240) is between 1.5 and 2.0.

6. A thin film solar cell module according to any preceding claim, wherein a thin film solar cell module further comprises an encapsulation layer (150, 250) arranged between the protective layer (140, 240) and the cover substrate (160, 260).

7. A thin film solar cell module according to claim 6, wherein a refractive index of the encapsulation layer (150, 250) is substantially equal to a refractive index of the cover substrate (160, 260).

8. A thin film solar cell module according to any preceding claim, wherein the protective layer (140, 240) has a thickness of from about 50 nm to about 1000 nm.

9. A thin film solar cell module according to any preceding claim, further comprising a pair of ribbons (130, 230) in electrical contact with the rear electrode layer (122, 222), wherein one of the pair of the ribbons (130, 230) is adjacent one end of the thin film solar cell (120, 220) and the other of the pair of the ribbons (130, 230) is adjacent an opposite end of the thin film solar cell (120, 220).

10. A thin film solar cell module according to claim 11, wherein the protective layer (140, 240) is arranged to cover the pair of ribbons (130, 230).

11. A thin film solar cell module according to any preceding claim, wherein the thin film solar cell (120) further comprises a buffer layer (126) arranged between the light absorption layer (124) and the transparent electrode layer (128), optionally wherein the protective layer (140, 240) is arranged to cover side surfaces of the buffer layer (126).

12. A thin film solar cell module according to any preceding claim, wherein the thin film solar cell module comprises a plurality of thin film solar cells (120, 220), wherein the protective layer (140, 240) of each thin film solar cell (120, 220) extends to join the protective layer (140, 240) of an adjacent thin film solar cell (120, 220), optionally wherein the thin film solar cell module comprises a common protective layer (140, 240) for all the thin film solar cells (120, 220).
